# EUROPÄISCHE PATENTSCHRIFT

(11) **EP 0 480 288 B1**
(45) Veröffentlichungstag und Bekanntmachung des Hinweises auf die Patenterteilung: **27.07.1994**
(21) Anmeldenummer: 91116741.9
(22) Anmeldetag: 01.10.1991
(51) Int. Cl.: C08G 73/10, B05D 1/20

(54) **Ultradünne thermostabile Bismaleinimidschichten sowie ein Verfahren zu ihrer Herstellung**
Ultrathin heat-stable bismaleinimide films and method of making them
Couches minces thermostables de bismaleimide et leur procédé de fabrication

(30) Priorität: 09.10.1990 DE 4032004
(43) Veröffentlichungstag der Anmeldung: 15.04.1992
(73) Patentinhaber: BASF Aktiengesellschaft, 67063 Ludwigshafen (DE)
(72) Erfinder: Fuchs, Harald, Dr., W-6719 Carlsberg (DE); Licht, Ulrike, Dr., W-6800 Mannheim 1 (DE); Schrepp, Wolfgang, Dr., W-6900 Heidelberg (DE)

(56) Entgegenhaltungen:
- DE-A- 3 639 380

## Beschreibung

Die Erfindung betrifft ultradünne thermostabile Bismaleinimidschichten sowie Verfahren zu ihrer Herstellung.

Polyimide werden als thermostabile Schichten im Halbleiterbereich in vielfältiger Weise eingesetzt. Sie können als Planarisierungsmittel, als Isolationsschicht oder auch als strukturierbares Dielektrikum in Form der löslichen Vorstufe - der Polyamidsäure - aufgebracht werden. Auch im Bereich der Flüssigkristalle spielen Polyimide als Orientierungsschicht eine große Rolle. Für Anwendungen als Isolationsmaterial im Bereich der Halbleiter sind Schichten mit sehr dünner, einheitlicher Schichtdicke erforderlich. Durch Spin-coating von Polyamidsäurelösungen sind bisher Schichten von nicht dünner als 1 µm darstellbar. Um zu noch geringeren Schichtdicken zu gelangen, wurde bereits die Langmuir-Blodgett-Technik herangezogen. So beschreibt u.a. die DE-A 36 39 380 die Herstellung von monomolekular aufgebauten Filmen, welche im wesentlichen aus einem Polyimid aufgebaut sind, wobei amphiphil modifizierte Polyamidsäure Langmuir-Blodgett-Schichten auf thermischem oder chemischem Wege in das Imid überführt werden.

In dem Bestreben thermostabile ultradünne Polymerschichten mit einem erweiterten Aufgabenprofil bereitzustellen, stellte sich die Aufgabe, diese insbesondere hinsichtlich der isolierenden Eigenschaften und der Möglichkeit der nachträglichen Strukturierung mittels energiereicher Strahlung zu verbessern oder die Funktionalisierung der Oberfläche mit Aminen zu ermöglichen.

Es wurde nun gefunden, daß sich mit thermostabilen homogenen Bismaleinimidschichten mit einer einstellbaren Schichtdicke von kleiner 1 µm, erhalten durch Imidisierung von ionischen, durch Umsetzung eines Reaktionsprodukts aus einem Diamin und Maleinsäureanhydrid mit einem langkettigen Amin mit 8 bis 30 C-Atomen entstandenen Vorläufern, die gestellte Aufgabe lösen läßt.

Die für die Bildung der erfindungsgemäßen Bismaleinimidschichten geeigneten ionischen Vorläufer werden durch Umsetzung eines Reaktionsproduktes aus Maleinsäureanhydrid mit einem Diamin ausgewäht aus der Gruppe von Bis-(-p-Aminophenyl)-fluoren, Bisanilin P, 4,4′-Bis-(p-Aminophenoxy)-biphenyl sowie 1,8-Diaminonaphthalin mit einem langkettigen Amin mit 8 bis 30 C-Atomen, vorzugsweise mit Octadecylamin oder auch Dimethyldodecylamin erhalten.

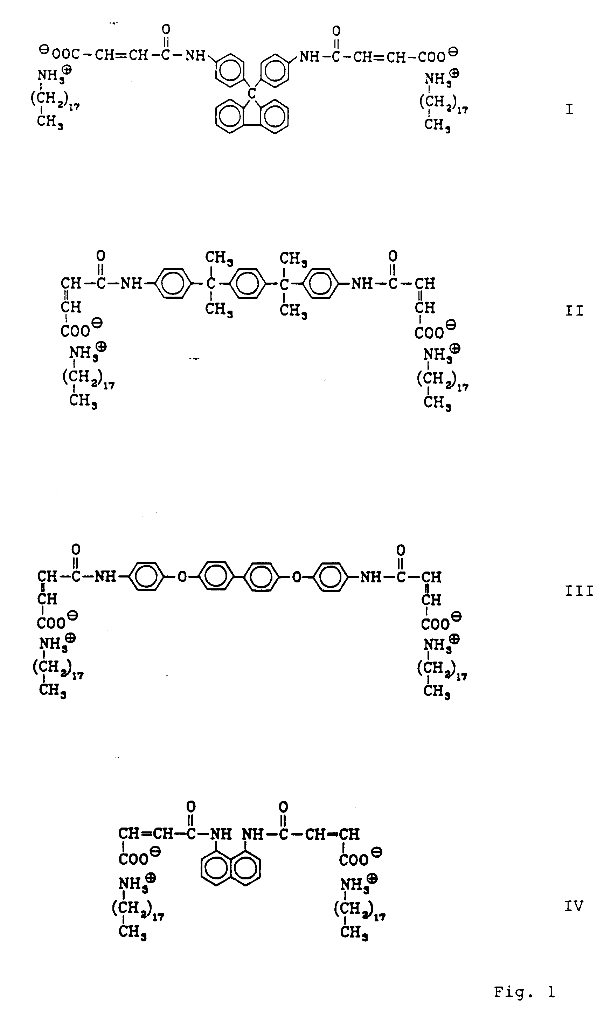

Derartig aufgebaute ionische Vorläufer sind die in Figur 1 wiedergebenen Verbindungen I bis IV.

Die Herstellung dieser Substanzen erfolgt in der Weise, daß zuerst ein Bismaleinsäureamid synthetisiert wird. Hierzu werden Lösungen des Diamins und des Maleinsäureanhydrids unter Zugabe eines Katalysators, wie z.B. Tributylamin oder Diazabicyclooctan, bei Temperaturen zwischen Raumtemperatur und 80°C zur Reaktion gebracht. Geeignete Lösungsmittel sind beispielsweise N-Methylpyrrolidon, N,N-Dimethylpropylenharnstoff und Dimethylacetamid. Die so erhaltenen Bismaleinsäureanhydride werden anschließend mit dem langkettigen Amin mit 8 bis 30 C-Atomen, vorzugsweise mit Octadecylamin oder auch mit Dimethyldodecylamin, zum ionischen Vorläufer umgesetzt.

Gemäß dem erfindungsgemäßen Verfahren wird nun zunächst eine Lösung des ionischen Vorläufers in einem organischen Lösungsmittel auf einer Wasseroberfläche ausgebreitet und nach dem Langmuir-Blodgett-Verfahren (LB-Verfahren, Polymer Surfaces and Interfaces, Hrsg. W.J. Feast u. H.S. Munro, 1987 John Wiley & Sons Ltd. , 163-187) eine Multischicht auf einem Substrat gebildet.

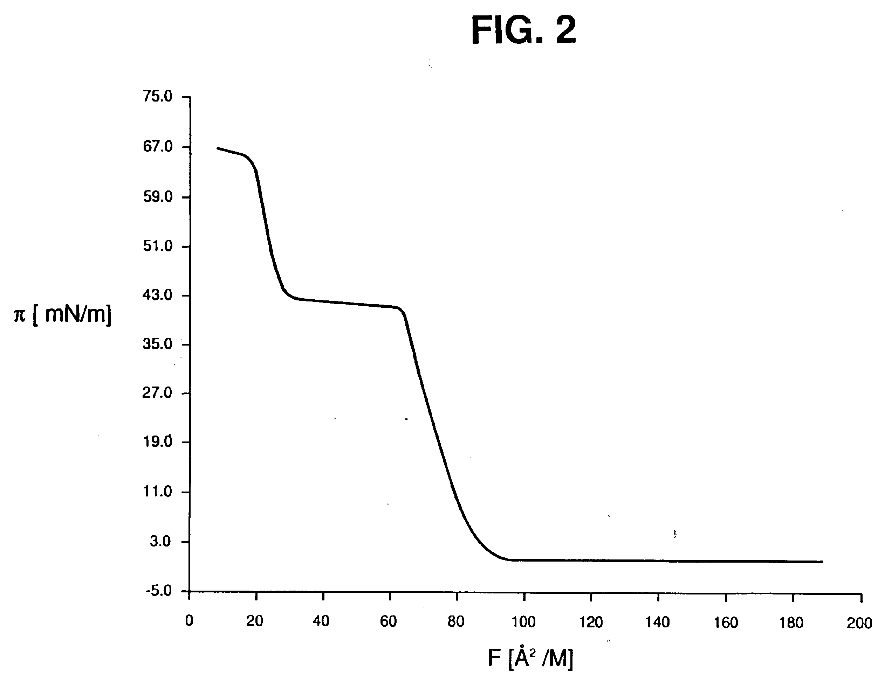

Voraussetzung zur Herstellung definierter Multischichten nach dem LB-Verfahren ist das Vorliegen einer stabilen Monoschicht auf der Wasseroberfläche des Langmuir-Troges. Dieses Verhalten läßt sich mittels sog. Druck/Flächen (π/A)-Diagramme charakterisieren (Figur 2). Hierbei wird der Oberflächendruck π, der der Differenz der Oberflächenspannung zwischen filmfreier und filmbedeckter Oberfläche des Langmuir-Troges entspricht, über dem molekularen Flächenbedarf A aufgetragen, welcher hier der Fläche pro Wiederholungseinheit entspricht. Die jeweiligen Maßeinheiten sind mN/m bzw. Å²/Molekül. Ein steiler Anstieg im π/A-Diagramm bei abnehmender Fläche ist günstig für eine Übertragung auf feste Träger. Ferner muß der Oberflächenfilm bei einem zur Übertragung geeigneten Druck stabil sein, d.h. er darf nicht kollabieren. Üblicherweise wird ein Druck zur Übertragung der Schichten gewählt, der deutlich unter dem Kollapsdruck liegt, aber der einen über längere Zeit stabilen Oberflächenfilm im festanalogen Zustand gewährleisten. Weiter muß die optimale Ein- und Austauchgeschwindigkeit mit Hilfe des Filmliftes ermittelt werden. Sie beträgt im vorliegenden Fall 1 bis 50, vorzugsweise 3 bis 5 mm/min.

Als zu beschichtende Substrate wurden vorwiegend Si-Wafer gewählt. Auch auf mit Gold, Aluminium oder Silber bedampfte Si-Wafer oder hydrophobisiertes Glas ist eine Multischichtübertragung möglich. Auf diese Träger ziehen die Schichten in der sogenannten Y-Konfiguration, d.h. Kopf an Kopf und Kette an Kette als Doppelschicht auf.

Solcherart aufgebaute Multischichten aus den ionischen Vorläufern werden nun durch Imidisierung in die erfindungsgemäßen homogenen Bismaleinimidschichten überführt. Diese Imidisierung ist sowohl auf thermischem als auch auf chemischem Wege durchführbar. So findet bei Temperaturen zwischen 150 und 300°C der Ringschluß zum Imid unter Austritt von Wasser statt. Eine Imidisierung auf chemischem Wege geschieht durch Behandlung mit Wasser entziehenden Mitteln. Hierfür eignen sich insbesondere Acetanhydrid, Pyridin, Thionylchlorid und Oxalsäuredichlorid. Die Imidisierung läßt sich gut IR-spektroskopisch verfolgen. Außerdem ist eine Verringerung der Schichtdicken feststellbar.

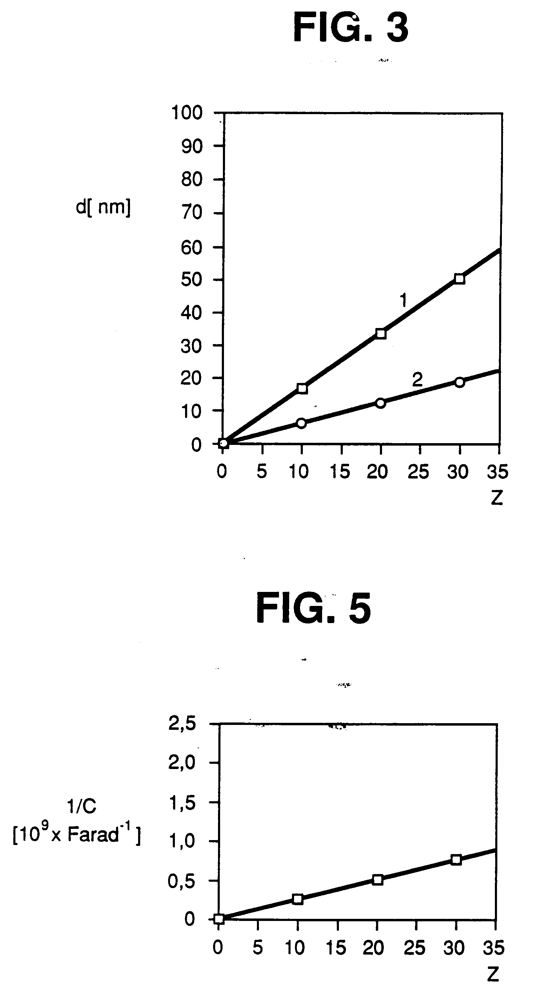

Mit dieser Imidisierung entstehen aus den LB-Multischichten des ionischen Vorläufers die homogenen Bismaleinimidschichten in einer Schichtdicke, welche sich in Abhängigkeit von der Anzahl der aufgezogenen Schichten des ionischen Vorläufers einstellen läßt. Figur 3 zeigt beispielhaft einen solchen Zusammenhang zwischen der Anzahl der Schichten (Z) und der Dicke d der Multischicht, wobei die Gerade 1) die Meßwerte für die Schichtdicke aus ionischem Vorläufer und der Gerade 2) diejenigen für die durch Imidisierung entstandene Bismaleinimidschicht wiedergibt.

Generell gilt, daß mit Hilfe des erfindungsgemäßen Verfahrens Schichtdicken von weniger als 1 µm, insbesondere solche zwischen 0,3 bis 500 nm herstellen lassen.

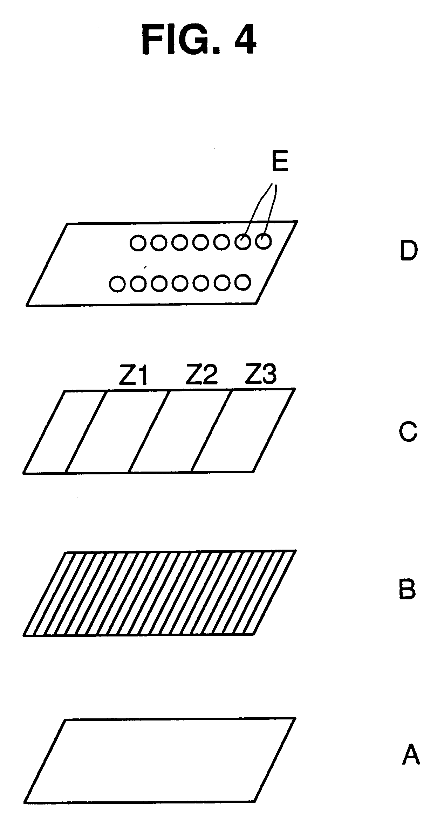

Die erfindungsgemäßen homogenen thermostabilen und ultradünnen Schichten lassen sich in besonders vorteilhafter Weise hinsichtlich ihrer dielektrischen Eigenschaften für Isolationszwecke heranziehen. Messungen der Kapazität derartiger dünner Schichten lassen sich mit einer Anordnung, wie schematisch in Figur 4 angezeigt, durchführen. Auf dem Si-Wafer A befindet sich als Basiselektrode eine Silberaufdampfschicht B. Darauf werden dann die LB-Schichten C in einer unterschiedlichen Schichtzahl Z1, Z2 und Z3 aufgebracht und durch eine Maske D Deckelektroden E aus Aluminium aufgedampft. Die Abhängigkeit der Kapazität, 1/C, in Farad⁻¹·10⁹ von der Schichtanzahl Z zeigt Figur 5. Die lineare Abhängigkeit von 1/C von der Schichtdicke belegt eine definierte und defekt freie Schichtübertragung.

## Patentansprüche

1. Thermostabile homogene Bismaleinimidschichten mit einer Schichtdicke von kleiner 1 µm, erhalten durch Imidisierung von ionischen, durch Umsetzung eines Reaktionsprodukts aus einem Diamin und Maleinsäureanhydrid mit einem langkettigen Amin mit 8 bis 30 C-Atomen entstandenen Vorläufern.

2. Verfahren zur Herstellung von thermostabilen homogenen Bismaleinimidschichten durch Aufbringen einer Multischicht eines ionischen Vorläufers, entstandenen durch Umsetzung eines Reaktionsprodukts aus einem Diamin und Maleinsäureanhydrid mit einem langkettigen Amin mit 8 bis 30 C-Atomen mittels der Langmuir-Blodgett-Technik auf ein Substrat, und Imidisieren dieses Vorläufers durch Erhitzen der Multischicht auf eine Temperatur zwischen 150 und 300°C.

3. Verfahren zur Herstellung von thermostabilen homogenen Bismaleinimidschichten durch Aufbringen einer Multischicht eines ionischen Vorläufers, entstandenen durch Umsetzung eines Reaktionsprodukts aus einem Diamin und Maleinsäureanhydrid mit einem langkettigen Amin mit 8 bis 30 C-Atomen mittels der Langmuir-Blodgett-Technik auf ein Substrat, und Imidisieren dieses Vorläufers mittels wasserentziehender Mittel.

## Claims

1. Thermally stable homogeneous bismaleimide layers having a thickness of less than 1µm, obtained by imidization of ionic precursors formed by reaction of a reaction product of a diamine and maleic anhydride with a long-chain amine having from 8 to 30 carbon atoms.

2. A process for preparing thermally stable homogeneous bismaleimide layers by applying a multilayer of an ionic precursor formed by reaction of a reaction product of a diamine and maleic anhydride with a long-chain amine having from 8 to 30 carbon atoms to a substrate by means of the Langmuir-Blodgett technique and imidizing this precursor by heating the multilayer to a temperature between 150 and 300°C.

3. A process for preparing thermally stable homogeneous bismaleimide layers by applying a multilayer of an ionic precursor formed by reaction of a reaction product of a diamine and maleic anhydride with a long-chain amine having from 8 to 30 carbon atoms to a substrate by means of the Langmuir-Blodgett technique and imidizing this precursor by means of water-withdrawing agents.

## Revendications

1. Couches de bismaléimide homogènes et thermostables, d'une épaisseur inférieure à 1 µm, que l'on obtient par l'imidation de précurseurs ioniques, formés par la réaction d'un produit de la réaction d'une diamine et de l'anhydride maléique avec une amine à longue chaîne comportant de 8 à 30 atomes de carbone.

2. Procédé de préparation de couches de bismaléimide homogènes et thermostables par l'application d'une multicouche d'un précurseur ionique, formé par la réaction du produit de la réaction d'une diamine et de l'anhydride maléique avec une amine à longue chaîne comportant de 8 à 30 atomes de carbone, à l'intermédiaire de la technique de Langmuir-Blodgett, sur un support et l'imidation de ce précurseur par chauffage de la multicouche à une température comprise entre 150 et 300°C.

3. Procédé de préparation de couches de bismaléimide homogènes et thermostables par l'application d'une multicouche d'un précurseur ionique, formé par la réaction du produit de la réaction d'une diamine et de l'anhydride maléique avec une amine à longue chaîne comportant de 8 à 30 atomes de carbone, à l'intermédiaire de la technique de Langmuir-Blodgett, sur un support et l'imidation de ce précurseur à l'aide d'agents d'enlèvement d'eau.
